# EUROPEAN PATENT SPECIFICATION

(11) **EP 2 157 591 B1**
(45) Date of publication and mention of the grant of the patent: **22.01.2014**
(21) Application number: 08014454.6
(22) Date of filing: 13.08.2008
(51) Int. Cl.: H01H 13/88

(54) **Electronic switch mountable on a circuit board and method for making the same**
Elektronischer Schalter, der an einer Leiterplatte anbringbar ist, und Herstellungsverfahren dafür
Interrupteur électronique montable sur une carte de circuit et son procédé de fabrication

(43) Date of publication of application: 24.02.2010
(73) Proprietor: Chou, Tien-Ming, Taichung City (TW)
(72) Inventor: Chou, Tien-Ming, Taichung City (TW)
(74) Representative: Winter, Brandl, Fürniss, Hübner, Röss, Kaiser, Polte - Partnerschaft

(56) References cited:
- EP-A- 0 367 204
- EP-A- 1 858 042
- WO-A-2008/010678
- DE-A1- 1 665 294
- DE-T2- 60 031 495

## Description

The invention relates to a switch, more particularly to an electronic switch mountable on a circuit board and a method for making the same.

Referring to Figs. 1 and 2, a conventional electronic switch 10, as disclosed by the applicant in Taiwanese Patent No. 155965, includes a top cover 11, a conductive ball 12 disposed in the top cover 11, a base 13, and four terminals 14. The top cover 11 is made of plastic, and has a cover main wall 111, and four interconnected sidewalls 112 extending downwardly from a peripheral end of the cover main wall 111. The cover main wall 111 and the sidewalls 112 cooperatively define a chamber 113 having a bottom opening 114. The conductive ball 12 is disposed in the chamber 113. The base 13 is made of plastic, and is inserted into the chamber 113 so as to close the bottom opening 114, thereby confining the conductive ball 12 within the chamber 113. The base 13 has top and bottom surfaces, and four spaced-apart through holes 131 extending through the top and bottom surfaces.

The terminals 14 are inserted respectively into the through holes 131 by a jig (not shown) so as to position the terminals 14 in the respective through holes 131. An epoxy resin 15 is filled within a space defined among the sidewalls 112 of the top cover 11, a bottom surface of the base 13, and the terminals 14, after which an assembly of the top cover 11, the base 13, and the terminals 14 is sent to an oven (not shown) so as to cure the epoxy resin 15, thereby obtaining the conventional electronic switch 10.

Although the aforementioned conventional electronic switch 10 can achieve its intended purpose, during heating of the assembly of the top cover 11, the base 13, and the terminals 14 in the oven, air in the chamber 113 expands when subjected to the high temperature of the oven, and escapes out of the electronic switch 10 through the epoxy resin 15. As a consequence, the epoxy resin 15 is formed with cracks 16, and the surface thereof is rough. Not only is the appearance of the electronic switch 10 affected, but also, the watertight capability of the electronic switch 10 is adversely affected due to the presence of the cracks 16. Hence, the electronic switch 10 gets moist easily, ultimately leading to reductions in the quality and service life of the electronic switch 10.

EP-A-1 858 042 discloses a touch panel unit which is provided with a design sheet attached to the surface of an upper electrode film of a touch panel such that the design sheet is protruded at its periphery from the touch panel and a touch-panel-unit casing which is integrally molded with the design sheet such that the casing is covered at its surface with the design sheet and surrounds the side surfaces of the touch panel.

An object of the present invention is to provide an electronic switch that is capable of overcoming the aforementioned drawbacks of the prior art.

According to an aspect of this invention, an electronic switch is provided as defined in claim 1. The electronic switch is mountable on a circuit board and comprises a housing, a terminal, a conductive ball, and a first adhesive layer. The housing includes a base having an inner side and an outer side opposite to the inner side, and a cover body having a main portion that cooperates with the inner side of the base to define a chamber, and an end portion extending from the main portion to the outer side of the base and cooperating with the outer side of the base to define a sealing space. The terminal has a connecting part extending through the base and the sealing space and adapted to be connected to the circuit board. The conductive ball is disposed rollably in the chamber. The first adhesive layer is disposed in the sealing space without covering the air-discharge hole. The electronic switch is characterized by a hollow portion that projects outwardly from the outer side of the base into the sealing space, an air-discharge hole communicating fluidly with the chamber and extending through the hollow portion, and a sealing unit attached to the base and including a plug body inserted into the air-discharge hole to seal the air-discharge hole.

Other features and advantages of the present invention will become apparent in the following detailed description of the preferred embodiments with reference to the accompanying drawings, of which:

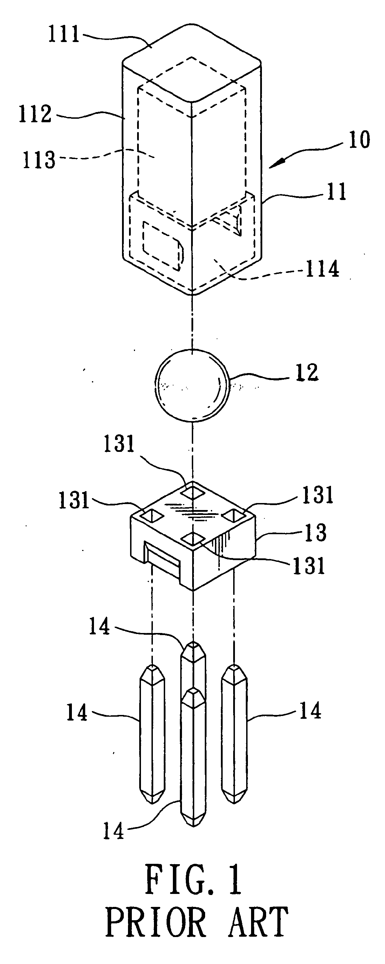

Fig. 1 is an exploded perspective view of a conventional electronic switch disclosed in Taiwanese Patent No. 155965;

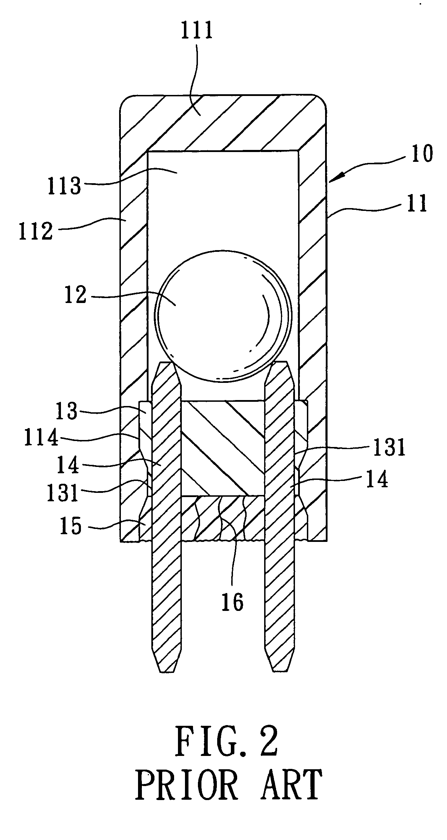

Fig. 2 is a sectional view of the conventional switch of Fig. 1 in an assembled state;
Fig. 3 is a flow chart, illustrating the steps involved in making an electronic switch according to the first preferred embodiment of the present invention;
Fig. 4 is an exploded perspective view of the electronic switch of the first preferred embodiment;
Fig. 5 is a perspective view of the first preferred embodiment in an assembled state;
Fig. 6 is a sectional view of the first preferred embodiment taken along line VI-VI of Fig. 5;
Fig. 7 is a sectional view of the first preferred embodiment embodiment taken along line VII-VII of Fig. 5;
Fig. 8 is an exploded perspective view of an electronic switch according to the second preferred embodiment of the present invention;
Fig. 9 is a sectional view of the second preferred embodiment in an assembled state; and
Fig. 10 is another sectional view of the second preferred embodiment in an assembled state.

Before the present invention is described in greater detail, it should be noted that the same reference numerals have been used to denote like elements throughout the specification.

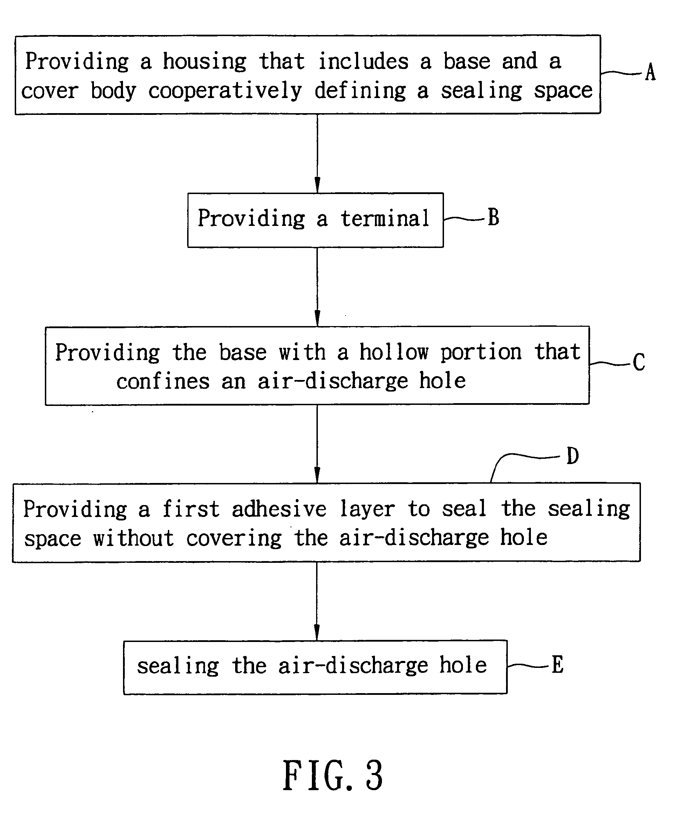

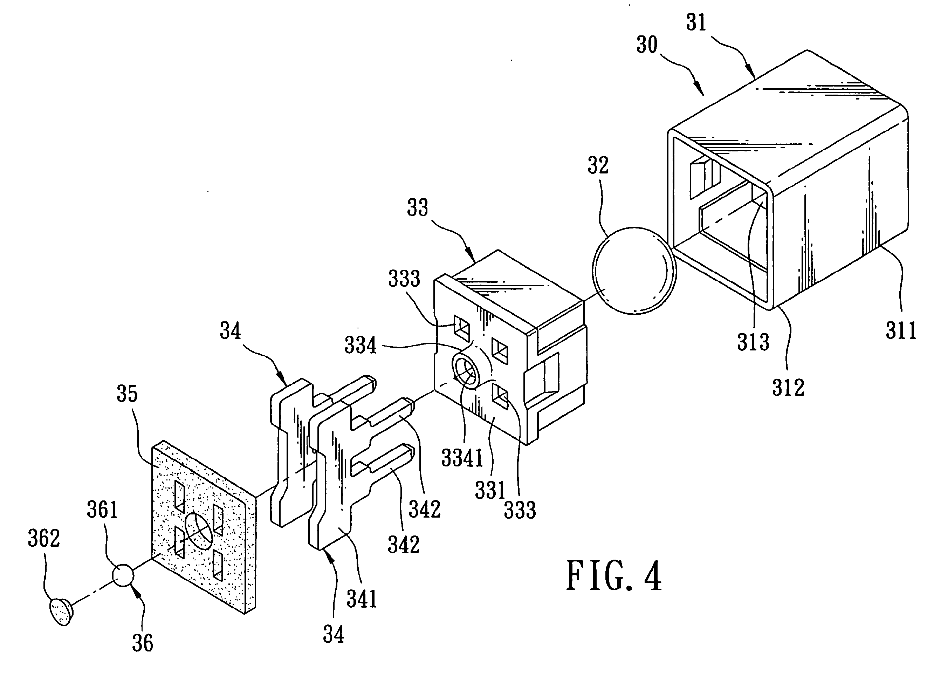

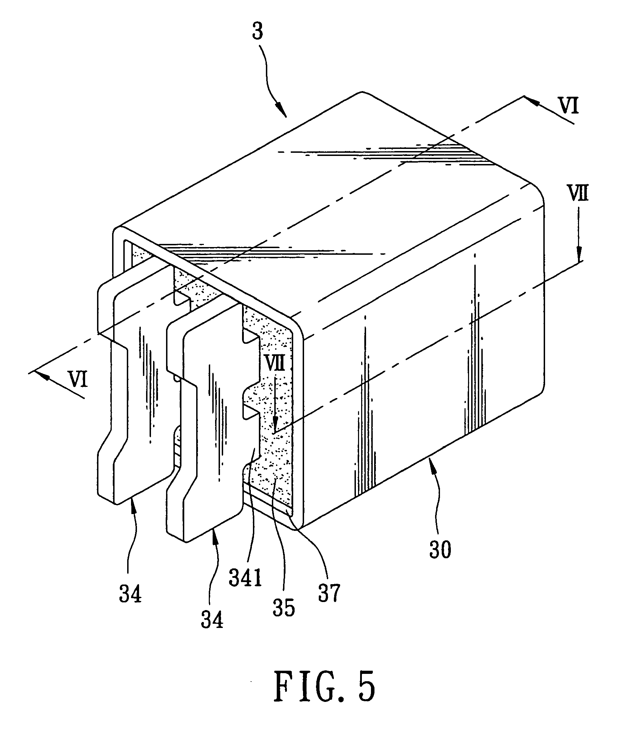

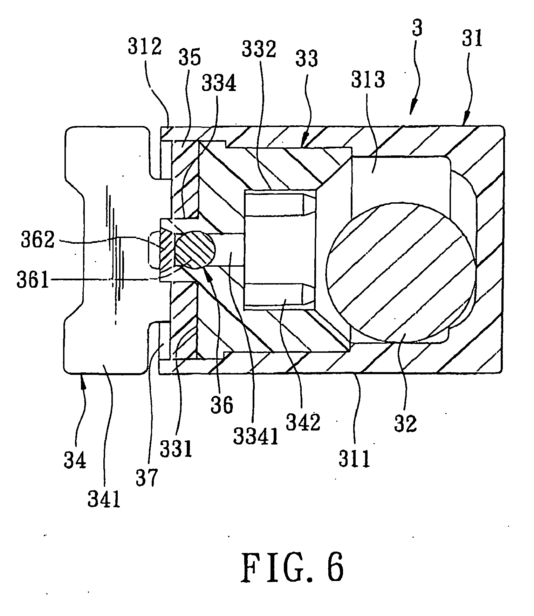

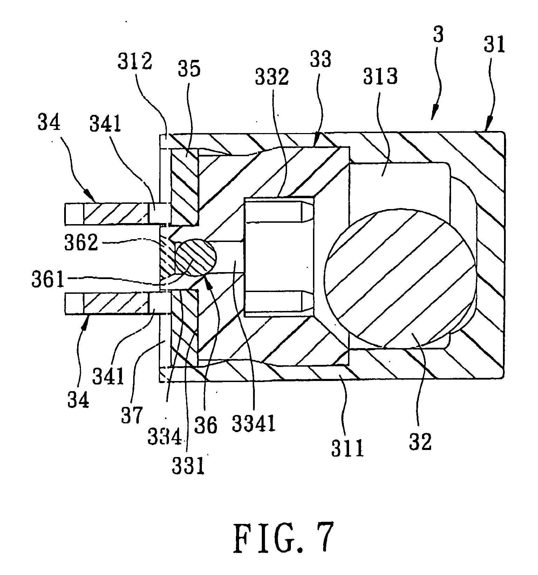

Referring to Fig. 3, a method for making an electronic switch 3 according to the first preferred embodiment of the present invention is shown to comprise steps (A) to (E). These steps (A) to (E) will be described in greater detail below in combination with Figs. 4 to 7.

In step (A), a housing 30 is provided. The housing 30 includes a base 33, a cover body 31, and a conductive ball 32. The base 33 is made of plastic, and has an inner side 332, an outer side 331 opposite to the inner side 332, and four spaced-apart through holes 333 extending through the outer and inner sides 331, 332 and communicating fluidly with a chamber 313. The cover body 31 is made of plastic, and has a main portion 311 that cooperates with the inner side 332 of the base 33 to define the chamber 313, and an end portion 312 extending from the main portion 311 to the outer side 331 of the base 33 and cooperating with the outer side 331 to define a sealing space 37. The conductive ball 32 is disposed rollably in the chamber 313.

In step (B), two terminals 34 are provided on the housing 30. In this embodiment, each of the terminals 34, has a connecting part 341 extending through the base 33 and the sealing space 37 and adapted to be connected to a circuit board (not shown), and two spaced-apart contact parts 342 extending from the connecting part 341 into the chamber 313 so as to contact the conductive ball 32. The two contact parts 342 of each terminal 34 are inserted through the respective two of the through holes 333 in the base 33 and into the chamber 313 by using a jig (not shown).

In step (C), the base 33 is provided with a hollow portion 334 that projects outwardly from the outer side 331 of the base 33 and that confines an air-discharge hole 3341 communicating fluidly with the chamber 313.

In step (D), a first adhesive layer 35 is disposed in the sealing space 37 without covering the air-discharge hole 3341.

In step (E), after the first adhesive layer 35 is cured, a sealing unit 36 is attached to the base 33 so as to seal the air-discharge hole 3341. A common method to cure the first adhesive layer 35 quickly so as to shorten the manufacturing time is to place the housing 30 in an oven (not shown) that is set to a high temperature. However, natural curing at room temperature may also be employed to cure the first adhesive layer 35, in which case the manufacturing time is increased. In either case, during curing of the first adhesive layer 35, air in the chamber 313 can be discharged outwardly of the housing 30 via the air-discharge hole 3341, so that cracks in the first adhesive layer 35 are not formed. Hence, an outer surface of the first adhesive layer 35 remains flat and smooth, thereby enhancing an appearance of the housing 30.

The sealing unit 36, in this embodiment, includes a plug body 361 and a second adhesive layer 362. The plug body 361 is a steel ball having a diameter larger than that of the air-discharge hole 3341. The steel ball or plug body 361 is inserted into the air-discharge hole 3341 by using a jig (not shown), after which the second adhesive layer 362 is disposed in the air-discharge hole 3341 externally of the plug body 361, thereby sealing any gaps that may be present between the air-discharge hole 3341 and the plug body 361.

Finally, after the second adhesive layer 362 is cured, the electronic switch 3 of the first preferred embodiment is obtained. In this embodiment, the electronic switch 3 is a contact-type electronic switch.

The electronic switch 3 of the first preferred embodiment, as described above, comprises the housing 30 including the cover body 31, the conductive ball 32, and the base 33, the two terminals 34, the hollow portion 334, the first adhesive layer 35, and the sealing unit 36.

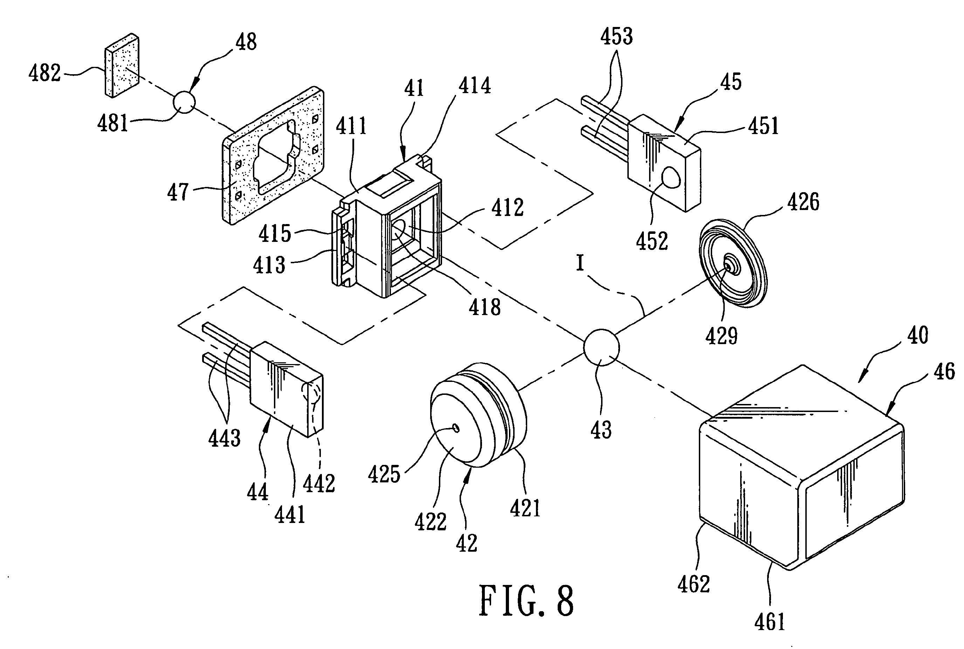

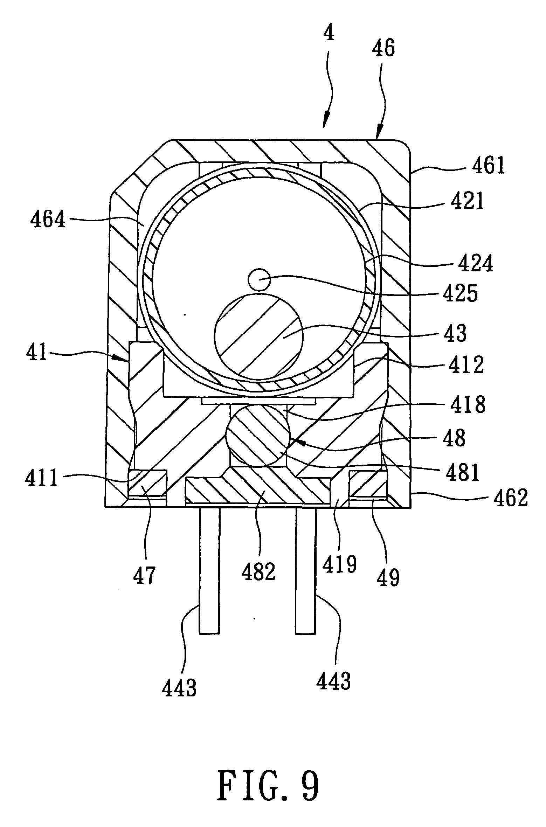

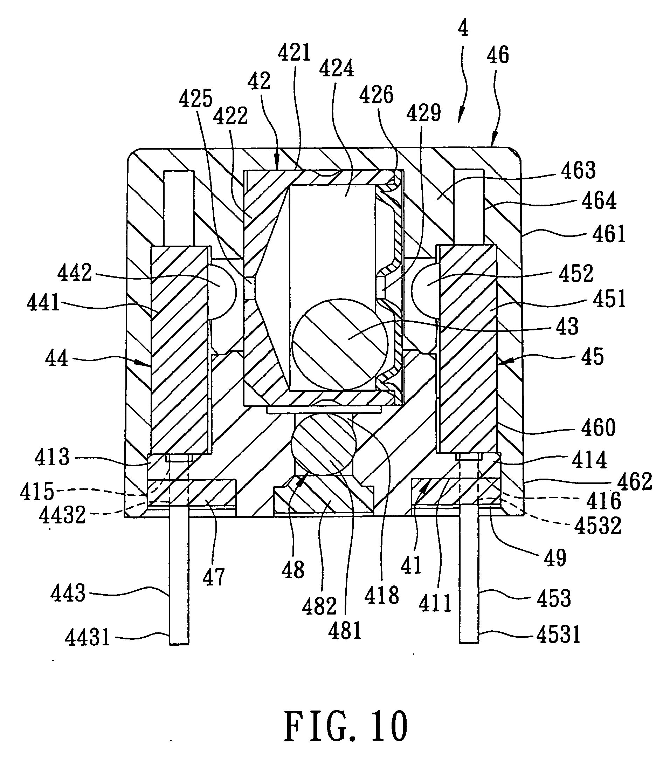

Referring to Figs. 8 to 10, in combination with Fig. 3, a method for making an electronic switch 4 according to the second preferred embodiment of the present invention is shown to be similar to the first preferred embodiment. Particularly, the method comprises the steps (A) to (E).

In step (A), a housing 40 is provided. The housing 40 includes a base 41 and a cover body 46. The base 41 includes an inner side 412, an outer side 411 opposite to the inner side 412, and first and second wing plates 413, 414 extending outwardly and oppositely from the outer side 411. Each of the first and second wing plates 413, 414 is formed with two spaced-apart through holes 415, 416. The cover body 46 has a main portion 461, and an end portion 462 extending from the main portion 461 to the outer side 411 of the base 41 and cooperating with the outer side 411 to define a sealing space 49. The main portion 461 has an annular rib 463 projecting downwardly from an upper inner wall face thereof and cooperating with the inner side 412 of the base 41 to define a chamber 464.

In step (B), two terminals 443 and two terminals 453 are provided in the chamber 464. Each of the terminals 443, 453 has a connecting part 4431, 4531 extending through the base 41 and the sealing space 49 and adapted to be connected to a circuit board (not shown), and a coupling part 4432, 4532 extending from the connecting part 4431, 4531 into the respective through hole 415, 416. A light emitter 44 is coupled to the coupling parts 4432 of the terminals 443, and includes an emitter main body 441 seated on the first wing plate 413, and an emitter head 442 projecting from one side of the emitter main body 441 to emit a light signal. A light receiver 45 is coupled to the coupling parts 4532 of the terminals 453, and includes a receiver main body 451 seated on the second wing plate 414, a receiver head 452 projecting from one side of the receiver main body 451 to receive the light signal emitted by the emitter head 442. The annular rib 463 presses against the emitter and receiver main bodies 441, 451.

A receptacle 42 is disposed between the base 41 and the cover body 46, and includes a first wall 422 proximate to the light emitter 44 and having a light entry hole 425 aligned with the emitter head 442, a second wall 426 opposite to the first wall 422 and proximate to the light receiver 45, and a tubular wall 421 connected between the first and second walls 422, 426. The first and second walls 422, 426 and the tubular wall 421 cooperatively define a chamber 424. The first wall 422 and the tubular wall 421 are formed integrally, while the second wall 426 is a plate formed separately from the tubular wall 421. The second wall 426 abuts against an end face of the tubular wall 421, and has a light exit hole 429 aligned with the receiver head 452. The light entry hole 425 and the light exit hole 429 are aligned with each other along a light path (I).

A conductive ball 43 is disposed rollably within the chamber 424 between the light emitter 44 and the light receiver 45, and has a diameter smaller than a distance from the tubular wall 421 to the light path (I), so that the conductive ball 43 can block and unblock the light path (I).

In step (C), the base 41 is provided with a hollow portion 419 that projects outwardly from the outer side 411 of the base 41 and that confines an air-discharge hole 418 communicating fluidly with the chamber 464.

In step (D), a first adhesive layer 47 is disposed in the sealing space 49 without covering the air-discharge hole 418.

In step (E), after the first adhesive layer 47 is cured, a sealing unit 48 is attached to the base 41 so as to seal the air-discharge hole 418. Similarly, the housing 40 may be placed in a high-temperature oven for quick curing of the first adhesive layer 47, or the first adhesive layer 47 may be cured naturally at room temperature. In either case, during curing of the first adhesive layer 47, air in the chamber 464 can be discharged outwardly of the housing 40 via the air-discharge hole 418, so that cracks are not formed in the first adhesive layer 47. Hence, an outer surface of the first adhesive layer 47 remains flat and smooth, thereby enhancing an appearance of the housing 40. The sealing unit 48, in this embodiment, includes a plug body 481 and a second adhesive layer 482. The plug body 481 is a steel ball having a diameter larger than that of the air-discharge hole 418. The steel ball or plug body 481 is inserted into the air-discharge hole 418 by using a jig (not shown), after which the second adhesive layer 482 is disposed in the air-discharge hole 418 externally of the plug body 481, thereby sealing any gaps that may be present between the air-discharge hole 418 and the plug body 481.

Finally, after the second adhesive layer 482 is cured, the electronic switch 4 of the second preferred embodiment is obtained. In this embodiment, the electronic switch 4 is a photoelectric switch.

The electronic switch 4 of the second preferred embodiment includes the base 41, the receptacle 42, the conductive ball 43, the terminals 443, the terminals 453, the light emitter 44, the light receiver 45, the cover body 46, the hollow portion 419, the first adhesive layer 47, and the sealing unit 48.

It is worth mentioning that although the sealing unit 36, 48 is described in the first and second preferred embodiments of the present invention as including the plug body 361, 481 and the second adhesive layer 362, 482, it is not limited as such. In an alternative embodiment, a sealing tape may be used to seal the air-discharge hole 3341, 418.

The advantages and effects of the present invention are summarized hereinafter.

Because air in the chamber 313, 464 can be discharged outwardly of the housing 30, 40 via the air-discharge hole 3341, 418 during curing of the first adhesive layer 35, 47, the first adhesive layer 35, 47 of the present invention is prevented from undergoing cracking. Hence, a watertight capability of the electronic switch 3, 4 of the present invention is maintained. This results in enhancing the quality and in prolonging the service life of the electronic switch 3, 4. Further, since the first adhesive layer 35, 47 has no cracks, an outer surface thereof remains flat and smooth, thereby enhancing the appearance of the present invention.

## Claims

1. An electronic switch (3, 4) mountable on a circuit board, comprising:
a housing (30, 40) including a base (33, 41) having an inner side (332, 412) and an outer side (331, 411) opposite to said inner side (332, 412), and a cover body (31, 46) having a main portion (311, 461) that cooperates with said inner side (332, 412) of said base (33, 41) to define a chamber (313, 464), and an end portion (312, 462) extending from said main portion (311, 461) to said outer side (331, 411) of said base (33, 41) and cooperating with said outer side (331, 411) of said base (33, 41) to define a sealing space (37, 49);
a terminal (34, 443, 453) having a connecting part (341, 4431, 4531) extending through said base (33, 41) and said sealing space (37, 49) and adapted to be connected to the circuit board;
a hollow portion (334, 419) that projects outwardly from said outer side (331, 411) of said base (33, 41) into said sealing space (37, 49);
an air-discharge hole (3341, 418) communicating fluidly with said chamber (313, 464);
a first adhesive layer (35, 47) disposed in said sealing space (37, 49) without covering said air-discharge hole (3341, 418) **characterised by**
a sealing unit (36, 48) attached to said base (33, 41) and including a plug body (361, 481) inserted into said air-discharge hole (3341, 418) to seal said air-discharge hole (3341, 418); and
a conductive ball (32, 43) disposed rollably in said chamber (313, 464).

2. The electronic switch (3, 4) of Claim 1, **characterized in that** said sealing unit (36, 48) includes a second adhesive layer (362, 482) to seal said air-discharge hole (334, 418) externally of said plug body (361, 481).

3. The electronic switch (4) of Claim 1 or 2, further **characterized by**:
a light emitter (44) disposed in said chamber (464) and having an emitter head (442) to emit a light signal; and
a light receiver (45) disposed in said chamber (464) opposite to said light emitter (44) and having a receiver head (452) to receive the light signal emitted by said emitter head (442);
said conductive ball (43) being disposed rollably between said light emitter (44) and said light receiver (45).

## Patentansprüche

1. Elektronischer Schalter (3, 4), der auf einer Schaltungsplatine montierbar ist, mit:
einem Gehäuse (30, 40), das eine Basis (33, 41), die eine Innenseite (331, 411) und eine der Innenseite (332, 412) gegenüberliegende Außenseite (331,411) aufweist, und einen Abdeckungskörper (31, 46) enthält, der einen Hauptabschnitt (311, 461), der mit der besagten Innenseite (332, 412) der besagten Basis (33, 41) zusammenwirkt, um eine Kammer (313, 464) zu definieren, und einen Endabschnitt (312, 462) aufweist, der sich von dem Hauptabschnitt (311, 461) zu der Außenseite (331, 411) der Basis (33, 41) erstreckt und mit der Außenseite (331, 411) der Basis (33, 41) zusammenwirkt, um einen abgedichteten bzw. abdichtenden Raum (37, 49) zu definieren;
einem Anschluss (34, 443, 453), der einen verbindenden Abschnitt (341, 4431, 4531) aufweist, der sich durch die Basis (33, 41) und den abgedichteten Raum (37, 49) hindurch erstreckt und für eine Verbindung mit der Schaltungsplatine ausgelegt ist;
einem hohlen Abschnitt (334, 419), der von der Außenseite (331, 411) der Basis (33, 41) nach außen in den abgedichteten Raum (37, 49) hinein vorsteht;
einem Luftauslassloch (3341, 418), das mit der Kammer (313, 464) in Fluidverbindung steht;
einer ersten Klebeschicht (35, 47), die in dem abgedichteten Raum (37, 49) angeordnet ist, ohne das Luftauslassloch (3341, 418) abzudecken, **gekennzeichnet durch**
eine abdichtende Einheit (36, 48), die an der besagten Basis (33, 41) angebracht ist und einen Stopfenkörper (361, 481) aufweist, der in das Luftauslassloch (3341, 418) eingeführt ist, um das Luftauslassloch (3341, 418) abzudichten; und
eine leitende Kugel (32, 43), die in der besagten Kammer (313, 464) rollbar angeordnet ist.

2. Elektronischer Schalter (3, 4) nach Anspruch 1, **dadurch gekennzeichnet, dass** die abdichtende Einheit (36, 48) eine zweite Klebeschicht (362, 482) für die Abdichtung des Luftauslasslochs (334, 418) außerhalb des Stopfenkörpers (361, 481) enthält.

3. Elektronischer Schalter (4) nach Anspruch 1 oder 2, der weiterhin aufweist:
einen Lichtsender (44), der in der Kammer (464) angeordnet ist und einen Sendekopf (442) für die Aussendung eines Lichtsignals aufweist; und
einen Lichtempfänger (45), der in der besagten Kammer (464) entgegengesetzt zu dem Lichtsender (44) angeordnet ist und einen Empfängerkopf (452) für den Empfang des Lichtsignals aufweist, das von dem besagten Sendekopf (442) emittiert ist;
wobei die leitende Kugel (43) rollbar zwischen dem Lichtsender (44) und dem Lichtempfänger (45) angeordnet ist.

## Revendications

1. Commutateur électronique (3, 4) installable sur une carte de circuit imprimé, comprenant :
un logement (30, 40) incluant une base (33, 41) ayant un côté interne (332, 412) et un côté externe (331, 411) opposé audit côté interne (332, 412), et un corps de couvercle (31, 46) ayant une portion principale (311, 461) qui coopère avec ledit côté interne (332, 412) de ladite base (33, 41) pour définir une chambre (313, 464), et une portion d'extrémité (312, 462) s'étendant de ladite portion principale (311, 461) audit côté externe (331, 411) de ladite base (33, 41) et coopérant avec ledit côté externe (331, 411) de ladite base (33, 41) pour définir un espace d'étanchéité (37, 49) ;
une borne (34, 443, 453) ayant une partie de connexion (341, 4431, 4531) s'étendant à travers ladite base (33, 41) et ledit espace d'étanchéité (37, 49) et adaptée pour être connectée à la carte de circuit imprimé ;
une portion creuse (334, 419) qui fait saillie vers l'extérieur depuis ledit côté externe (331, 411) de ladite base (33, 41) dans ledit espace d'étanchéité (37, 49) ;
un trou d'évacuation d'air (3341, 418) communiquant fluidiquement avec ladite chambre (313, 464) ;
une première couche adhésive (35, 47) disposée dans ledit espace d'étanchéité (37, 49) sans couvrir ledit trou d'évacuation d'air (3341, 418), **caractérisé par**
une unité d'étanchéité (36, 48) fixée à ladite base (33, 41) et incluant un corps de bouchon (361, 481) inséré dans ledit trou d'évacuation d'air (3341, 418) pour étancher ledit trou d'évacuation d'air (3341, 418) ; et
une bille conductrice (32, 43) disposée avec faculté de roulement dans ladite chambre (313, 464).

2. Commutateur électronique (3, 4) selon la revendication 1, **caractérisé en ce que** ladite unité d'étanchéité (36, 48) inclut une seconde couche adhésive (362, 482) pour étancher ledit trou d'évacuation d'air (334, 418) à l'extérieur dudit corps de bouchon (361, 481).

3. Commutateur électronique (4) selon la revendication 1 ou 2, **caractérisé en outre par** :
un émetteur de lumière (44) disposé dans ladite chambre (464) et ayant une tête d'émetteur (442) pour émettre un signal lumineux ; et
un récepteur de lumière (45) disposé dans ladite chambre (464) opposé audit émetteur de lumière (44) et ayant une tête de récepteur (452) pour recevoir le signal lumineux émis par ladite tête d'émetteur (442) ;
ladite bille conductrice (43) étant disposée avec faculté de roulement entre ledit émetteur de lumière (44) et ledit récepteur de lumière (45).
